(19) 

Europäisches
Patentamt
European
Patent Office
Office européen
des brevets

(11)  **EP 4 518 091 A1**

(12)  **EUROPEAN PATENT APPLICATION**

(43) Date of publication:
05.03.2025  Bulletin 2025/10

(51) International Patent Classification (IPC):
*H02J 7/00* (2006.01)  *H02M 7/483* (2007.01)

(21) Application number: 24197485.6

(22) Date of filing: 30.08.2024

(52) Cooperative Patent Classification (CPC):
H02J 7/00032; H02J 7/0013; H02J 7/0016;
H02J 7/0063; H02M 1/0077; H02M 7/4835

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 01.09.2023 US 202363536326 P
09.04.2024 US 202418630632

(71) Applicant: Cypress Semiconductor Corporation
San Jose, CA 95134-1709 (US)

(72) Inventors:
• HEALY, Mark
P12 DR77 Macroom, Cork (IE)
• KIZZIAR, John
99224 Spokane, Washington (US)
• WALSH, Paul
T12 KAH9 Ballintemple, Cork, (IE)

(74) Representative: Murgitroyd & Company
165-169 Scotland Street
Glasgow G5 8PL (GB)

(54)  **BATTERY CLUSTER CONTROL**

(57)   According to some embodiments, a method includes connecting a first cluster controller of a first battery cluster to a serial communication bus, connecting a second cluster controller of a second battery cluster to the serial communication bus, sending synchronization data to the first cluster controller and the second cluster controller over the serial communication bus, controlling a first bridge of the first battery cluster to connect a first battery terminal of the first battery cluster to an output terminal based on the synchronization data and a first rank assigned to the first battery cluster to generate a first component of a waveform, and controlling a second bridge of the second cluster to connect a second battery terminal of the second battery cluster to the output terminal based on the synchronization data and a second rank assigned to the second battery cluster to generate a second component of the waveform.

Fig. 1

EP 4 518 091 A1

**Description**

**RELATED APPLICATION(S)**

This application claims priority to US Provisional 63/536,326 filed on September 1, 2023, the entirety of which is hereby incorporated by reference herein.

**BACKGROUND**

Battery powered systems, such as electric vehicles, use a direct current (DC) battery module for storing power. Some loads in the system may require an alternating current (AC) power supply. Inverters and voltage regulators may be provided to convert the voltage level of a power supply or to convert from a DC supply to an AC supply or from an AC supply to a DC supply.

**SUMMARY**

This Summary is provided to introduce a selection of concepts in a simplified form that are further described below in the Detailed Description. This Summary is not intended to identify key factors or essential features of the claimed subject matter, nor is it intended to be used to limit the scope of the claimed subject matter.

According to some embodiments, a method comprises connecting a first cluster controller of a first battery cluster to a serial communication bus, connecting a second cluster controller of a second battery cluster to the serial communication bus, sending synchronization data to the first cluster controller and the second cluster controller over the serial communication bus, controlling a first bridge of the first battery cluster to connect a first battery terminal of the first battery cluster to an output terminal based on the synchronization data and a first rank assigned to the first battery cluster to generate a first component of a waveform, and controlling a second bridge of the second cluster to connect a second battery terminal of the second battery cluster to the output terminal based on the synchronization data and a second rank assigned to the second battery cluster to generate a second component of the waveform.

According to some embodiments, a system comprises means for connecting a first cluster controller of a first battery cluster to a serial communication bus, means for connecting a second cluster controller of a second battery cluster to the serial communication bus, means for sending synchronization data to the first cluster controller and the second cluster controller over the serial communication bus, means for controlling a first bridge of the first battery cluster to connect a first battery terminal of the first battery cluster to an output terminal based on the synchronization data and a first rank assigned to the first battery cluster to generate a first component of a waveform, and means for controlling a second bridge of the second cluster to connect a second battery terminal of the second battery cluster to the output terminal based on the synchronization data and a second rank assigned to the second battery cluster to generate a second component of the waveform.

According to some embodiments, a battery cluster controller comprises a serial interface configured to receive synchronization data over a serial communication bus, a modulation unit configured to generate a bridge configuration signal to control a bridge for selectively connecting a battery element to an output terminal to generate a first component of a waveform based on a rank assigned to the battery cluster controller, and a delay unit configured to delay the bridge configuration signal based on the synchronization data to generate a delayed bridge configuration signal, wherein the bridge is controlled based on the delayed bridge configuration signal. In some embodiments the synchronization data may comprise a component of a total propagation delay for the serial communication bus and the component may be associated with a position of the battery cluster controller on the serial communication bus. In some embodiments the position may comprise a ring position in the serial communication bus. In some embodiments the delay unit may comprise a programmable delay counter configured based on the component. In some embodiments the serial interface may be configured to receive an address automatically assigned to the battery cluster controller according to a protocol of the serial communication bus.

According to some embodiments, a system comprises an output terminal, a serial communication bus, a first battery cluster comprising a first battery element, a first bridge configured to selectively connect the first battery element to the output terminal based on a state of the first bridge, and a first cluster controller connected to first bridge and the serial communication bus, a second battery cluster comprising a second battery element, a second bridge configured to selectively connect the second battery element to the output terminal based on a state of the second bridge, and a second cluster controller connected to the second bridge and the serial communication bus, and a host processor configured to send synchronization data to the first cluster controller and the second cluster controller over the serial communication bus, wherein the first cluster controller is configured to control the first bridge to connect the first battery element to the output terminal based on the synchronization data and a first rank assigned to the first battery cluster to generate a first component of a waveform, and the second cluster controller is configured to control the second bridge to connect the second battery element to the output terminal based on the synchronization data and a second rank assigned to the second battery cluster to generate a second component of the waveform.

To the accomplishment of the foregoing and related ends, the following description and annexed drawings set forth certain illustrative aspects and implementations. These are indicative of but a few of the various ways in which one or more aspects may be employed. Other aspects, advantages, and novel features of the disclosure will become apparent from the following detailed description when considered in conjunction with the annexed drawings.

## DESCRIPTION OF THE DRAWINGS

Fig. 1 is a schematic diagram of a battery system, in accordance with some embodiments.

Fig. 2 is a schematic diagram of a battery system illustrating latency mitigation, in accordance with some embodiments.

Fig. 3 is a schematic diagram of a cluster controller in a battery system, in accordance with some embodiments.

Fig. 4 is a waveform diagram illustrating an output waveform generated by a battery system, in accordance with some embodiments.

Fig. 5 is a flow diagram of a method for generating a waveform in a battery system, in accordance with some embodiments.

Fig. 6 illustrates an exemplary embodiment of a computer-readable medium, in accordance with some embodiments.

## DETAILED DESCRIPTION

The claimed subject matter is now described with reference to the drawings, wherein like reference numerals are used to refer to like elements throughout. In the following description, for purposes of explanation, numerous specific details are set forth in order to provide a thorough understanding of the claimed subject matter. It may be evident, however, that the claimed subject matter may be practiced without these specific details. In other instances, well-known structures and devices are shown in block diagram form in order to facilitate describing the claimed subject matter.

Equivalent or like elements or elements with equivalent or like functionality are denoted in the following description with equivalent or like reference numerals. As the same or functionally equivalent elements are given the same reference numbers in the figures, a repeated description for elements provided with the same reference numbers may be omitted. Hence, descriptions provided for elements having the same or like reference numbers are mutually exchangeable.

In this regard, directional terminology, such as "top", "bottom", "below", "above", "front", "behind", "back", "leading", "trailing", etc., may be used with reference to the orientation of the figures being described. Because parts of embodiments can be positioned in a number of different orientations, the directional terminology is used for purposes of illustration and is in no way limiting. It is to be understood that other embodiments may be utilized and structural or logical changes may be made without departing from the scope defined by the claims. The following detailed description, therefore, is not to be taken in a limiting sense.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (e.g., "between" versus "directly between," "adjacent" versus "directly adjacent," etc.).

In embodiments described herein or shown in the drawings, any direct electrical connection or coupling, i.e., any connection or coupling without additional intervening elements, may also be implemented by an indirect connection or coupling, i.e., a connection or coupling with one or more additional intervening elements, or vice versa, as long as the general purpose of the connection or coupling, for example, to transmit a certain kind of signal or to transmit a certain kind of information, is essentially maintained. Features from different embodiments may be combined to form further embodiments. For example, variations or modifications described with respect to one of the embodiments may also be applicable to other embodiments unless noted to the contrary.

The term "substantially" may be used herein to account for small manufacturing tolerances (e.g., within 5%) that are deemed acceptable in the industry without departing from the aspects of the embodiments described herein.

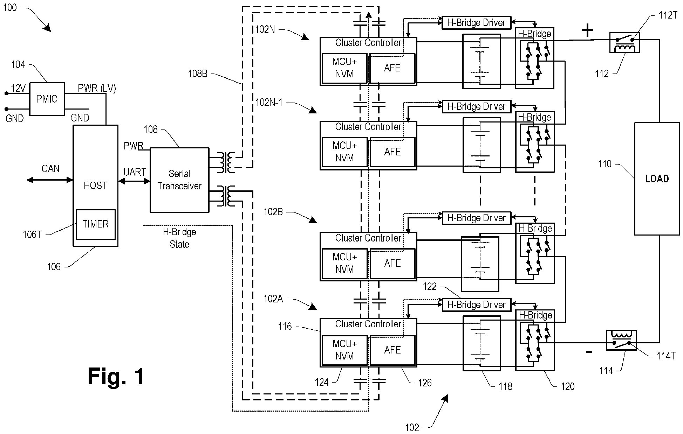

Fig. 1 is a schematic diagram of a battery system 100, in accordance with some embodiments. In some embodiments, the battery system 100 comprises battery clusters 102, individually referred to as battery clusters 102A, 102B, 102N-1, 102N, a power management integrated circuit (PMIC) 104 connected to a supply voltage (e.g. 12V) and a ground reference (e.g., chassis ground), a host processor 106 connected to the PMIC 104 to receive a low voltage (LV) power supply, and a serial transceiver 108 connected to between the host processor 106 and the battery clusters 102. The battery system 100 may be implemented in an electric vehicle, and the battery clusters 102 may provide power to a load 110, such as electric motors for moving the electric vehicle or other auxiliary loads in the electric vehicle. The battery system 100 is connected to the load 110 by a high side output relay 112 and a low side output relay 114 at output terminals 112T and 114T. The battery clusters 102 are subdivided and separately controlled elements of the main battery.

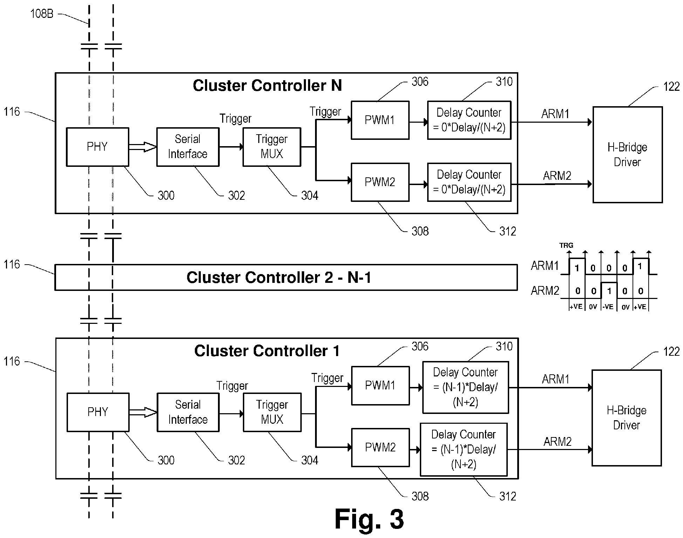

In some embodiments, each battery cluster 102 comprises a cluster controller 116, a battery element 118, an H-bridge 120 for selectively connecting the battery element 118 to the output relays 112 and 114, and an H-bridge driver 122 for controlling the state of the H-bridge 120. In some embodiments, the cluster controller 116 is implemented using Programmable System-on-a-Chip (PSoC°) hardware with programmable analog sub blocks that may be configured to control the battery clusters 102 based on direction from the host processor 106. The cluster controller 116 may comprise a processing unit 124 including a microcontroller and non-volatile memory (or some other type of memory) and an analog front end 126. In some embodiments, the analog front end 126 provides an interface for sensing characteristics of the battery elements 118, such as voltage, temperature, or other parameters. In some embodiments, the host processor 106 employs a Controller Area Network (CAN) protocol for communication to an external domain controller and a Universal Asynchronous Receiver-Transmitter (UART) protocol for communicating with the serial transceiver 108. The serial transceiver 108 may implement an isolated UART protocol (ISO-UART) protocol to communicate with corresponding serial interfaces 302 (see Fig. 3) in the cluster controllers 116. In some embodiments, the cluster controller 116 sends messages to the H-bridge driver 122 using a Serial Peripheral Interface (SPI) or Inter-Integrated Circuit (12C) protocol.

The H-bridge 120 comprises a set of switches that determine how the battery element 118 is connected to the output relays 112 and 114. In some embodiments, the state of the H-bridge 120 is controlled by the host processor 106 by sending a state message to the cluster controller 116. In some embodiments, the functionality for controlling the state of the H-bridge 120 is divided between the host processor 106 and the cluster controller 116. The H-bridge 120 may be configured by the H-bridge driver 122 to isolate the battery element 118 from the output relays 112 and 114, to connect the battery element 118 to the output relays 112 and 114 with a positive polarity, or to connect the battery element 118 to the output relays 112 and 114 with a negative polarity.

The number of battery clusters 102 may vary. The battery system 100 of Fig. 1 shows the arrangement for one phase of a three-phase system. Additional battery clusters 102 are provided for each phase (e.g., 16 clusters/phase * 3 phases = 48 battery clusters 102).

The battery clusters 102 may be controlled separately to generate a time varying waveform at the output terminals 112T or 114T for powering the load 110. For example, the states of the H-bridges 120 for the battery clusters 102 may be controlled to generate an AC waveform, such as a sinusoidal signal, at the output terminals 112T or 114T. Controlling the battery clusters 102 in this manner avoids the need to provide a separate inverter between the battery system 100 and the load 110 to generate the AC waveform.

In some embodiments, the cluster controllers 116 are connected in series on a serial communication bus 108B implemented by the serial transceiver 108. The cluster controllers 116 are connected in a daisy chain arrangement, whereby a cluster controller 116 forwards a message to the next cluster controller 116 in the daisy chain until all cluster controllers 116 have received the message. In some embodiments, the serial communication bus 108B is configured in a ring topology where messages for the host processor 106 are forwarded to the cluster controller 116 of the last battery cluster 102N in the daisy chain and then to the serial transceiver 108. For example in a ring topology messages are sent in a counterclockwise direction from the cluster controller 116 of the battery cluster 102A to the cluster controller 116 of the battery cluster 102N. Messages originating from one of the cluster controllers 116 are sent in the same direction to the serial transceiver 108 for forwarding to the host processor 106. A ring topology provides redundancy, since in the event a wire is broken in the ring, traffic can be re-routed in another direction.

In some embodiments, the serial communication bus 108B supports auto-addressing. During system initialization, the serial transceiver 108 identifies the cluster controllers 116 for the battery clusters 102 and assigns an address, such as a ring position, to each cluster controller 116. Initially, after power-up or interface timeout, each cluster controller 116 has an address of "0", The first bus address is assigned to the cluster controller 116 of the first battery cluster 102A responsive to receipt of a wake-up message from the serial transceiver 108. The cluster controller 116 of the first battery cluster 102A forwards the wake-up message to the cluster controller 116 of the second battery cluster 102B, resulting in an address being assigned to the cluster controller 116 of the second battery cluster 102B. The message forwarding and address assigning continues until all of the cluster controllers 116 of the battery clusters 102 have been assigned addresses. The serial transceiver 108 may communicate the configuration of the serial communication bus 108B and the attached cluster controllers 116 to the host processor 106.

On the serial communication bus 108B, the serial transceiver 108 provides isolation between the host processor 106 and the battery clusters 102, which are in different voltage domains. In an example for a 16-cluster, three-phase system, if the host processor 106 were to communicate in parallel with the cluster controllers 116 of the battery clusters 102, each connection between the host processor 106 and a cluster controller 116 would require 16 isolation circuits times three phases for a total of 48 isolation circuits. In addition parallel addressing does not support auto addressing, requiring production programming to address the battery clusters 102. The use of the serial topology reduces bill of material costs, reduces footprint, and decreases programming complexity.

On the serial communication bus 108B, there is inherent latency between when the host processor 106 sends a message to a target battery cluster 102 via the associated cluster controller 116 and when the target battery cluster 102 can receive and respond to or act on the message, for example to set the state of the H-bridge 120. Moreover, the latency differs depending on the location of the target battery cluster 102 in the chain on the serial communication bus 108B. To generate a 1 kHz waveform, such as a sine-wave, the H-bridge states would need to be updated at a minimum of every 10us and all battery clusters 102 need to be synchronized. This update frequency requires a differential latency of less than 500ns.

To meet the switch rate and latency limitations for generating a waveform for powering the load 110, the host processor 106 assigns delays to the various battery clusters 102. Upon receiving a command from the host processor 106, for example, to set the state of the H-bridge 120, the cluster controller 116 of the targeted battery cluster 102 delays the execution of the command based on the configured delay.

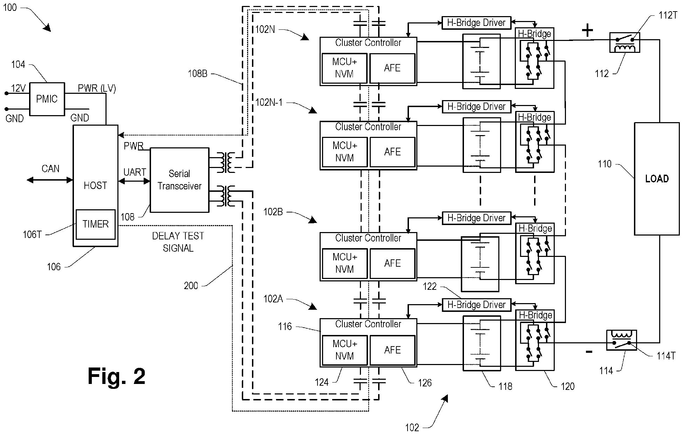

Fig. 2 is a schematic diagram of the battery system 100 illustrating latency mitigation, in accordance with some embodiments. In some embodiments, the host processor 106 sends a delay test signal 200 over the serial communication bus 108B and uses a timer 106T to calculate a total propagation delay. The total propagation delay includes a delay component from the serial transceiver 108 and the total delay resulting from the message forwarding on the serial communication bus 108B (e.g., to circle the ring). The total propagation delay is evenly distributed across the battery clusters 102 to generate synchronization data for the cluster controllers 116. For a given position on the serial communication bus 108B, represented by *DeviceNumber,* and a measured delay, *DELAY,* the synchronization data represented by the distributed delay for a given device is:

$$ProgDelay = (N - DeviceNumber) * \frac{DELAY}{N+2},$$

where the delay of the serial transceiver 108 and the serial interface 302 in the cluster controller 116 (2X) is incorporated into the N+2 denominator term (e.g., 18 with 16 battery clusters 102).

Fig. 3 is a schematic diagram of the cluster controllers 116 in the battery system 100, in accordance with some embodiments. In some embodiments, each cluster controller 116 comprises a physical layer (PHY) 300 for implementing signaling in the serial protocol (e.g., ISO-UART), a serial interface 302 for extracting data per the serial protocol, a trigger multiplexer 304, pulse width modulation (PWM) units 306 and 308 configured to generate bridge configuration signals, ARM1 and ARM2, for controlling the H-bridge driver 122 to set the state of the H-bridge 120, and delay counters 310 and 312 for delaying the bridge configuration signals ARM1 and ARM2, respectively. The delayed bridge configuration signals, ARM1 and ARM2 output by the delay counters 310 and 312 are connected to the H-bridge driver 122. In some embodiments, asserting the ARM1 while de-asserting the ARM2 signal controls the H-bridge driver 122 to connect the battery element 118 with positive polarity and asserting the ARM2 while de-asserting the ARM2 signal controls the H-bridge driver 122 to connect the battery element 118 with negative polarity. De-asserting both ARM1 and ARM2 disconnects the battery element 118. The trigger multiplexer 304 is part of a large group of programmable multiplexers that allow routing of trigger signals from any source to a destination peripheral.

In some embodiments, the PWMs 306 and 308 are configured to generate the ARM1 and ARM2 signals to control the state of the H-bridge 120. The ARM1 and ARM2 signals are delayed based on a value stored in the associated delay counter 310 and 312. For the cluster controller 116 in the first position (Cluster Controller 1), the delay may be (N-1) *Delay/(N+2) and for the cluster controller 116 in the last position (Cluster Controller 16), the delay may be 0*Delay/(N+2). The host processor 106 sends H-bridge state messages to the cluster controllers 116 to control the connections to the output terminals 112T, 114T to generate a waveform. By delaying the ARM1 and ARM2 signals based on the assigned loop prorogation delay, the relative timing between the changing states of the H-bridges 120 by the cluster controllers 116 is controlled.

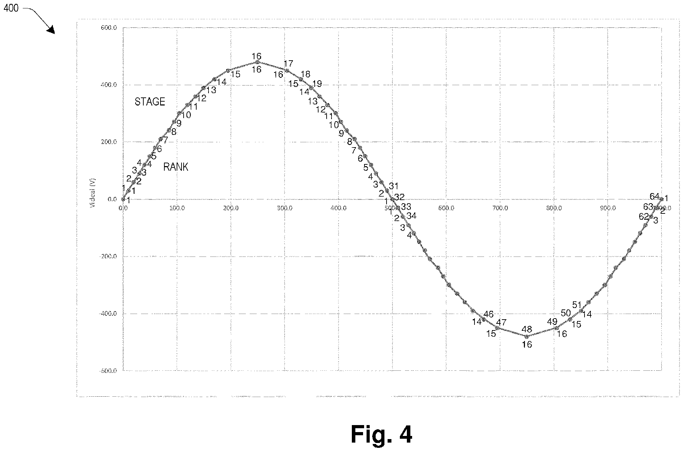

Fig. 4 is a waveform diagram illustrating an output waveform 400 generated by the battery system 100, in accordance with some embodiments. In some embodiments, the output waveform 400 may be a sinusoidal signal. The numbers above the output waveform 400 represent the stage number of the switching scheme (e.g. 4*N = 64 stages for one cycle of the waveform) and the numbers below the waveform represent the rank of the battery cluster 102 switching at the current time interval. In some embodiments, the rank does not correspond to the device number or the position of a cluster controller 116 on the serial communication bus 108B. For example, the battery clusters 102 may not switch sequentially. The rank represents the relative position of the cluster controller 116 in the switching scheme for generating the output waveform 400. The host processor 106 may determine the rank based on load balancing for the battery clusters 102. Moreover, the rank may change over time to provide load balancing.

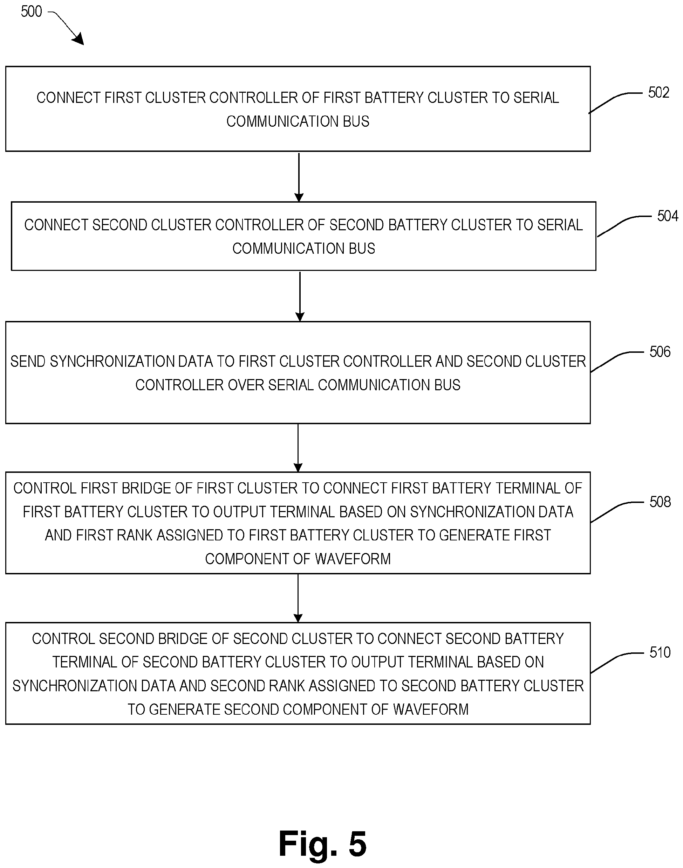

Fig. 5 is a flow diagram of a method 500 for generating an output waveform 400 in a battery system 100, in accordance with some embodiments. At 502, a first cluster controller 116 of a first battery cluster 102 is connected to a serial communication bus 108B. At 504, a second cluster controller 116 of a second battery cluster 102 is connected to the serial communication bus 108B. Connecting the cluster controller 116 to the serial communication bus 108B implies establishing communication with the cluster controller 116, which may include providing a physical connection, addressing, etc. At 506, synchronization data is sent to the first cluster controller 116 and the second cluster controller 116 over the serial communication bus 108B. At 508, a first bridge 120 of the first battery cluster 102 is controlled to connect a first battery terminal of the first battery cluster 102 to an output terminal 112T or an output terminal 114T based on the synchronization data and a first rank assigned to the first battery cluster 102 to generate a first component of an output waveform 400. At 510, a second bridge 120 of the second battery cluster 102 is controlled to connect a second battery terminal of the second battery cluster 102 to the output terminal 112T or the output terminal 114T based on the synchronization data and a second rank assigned to the second battery cluster 102 to generate a second component of the output waveform 400.

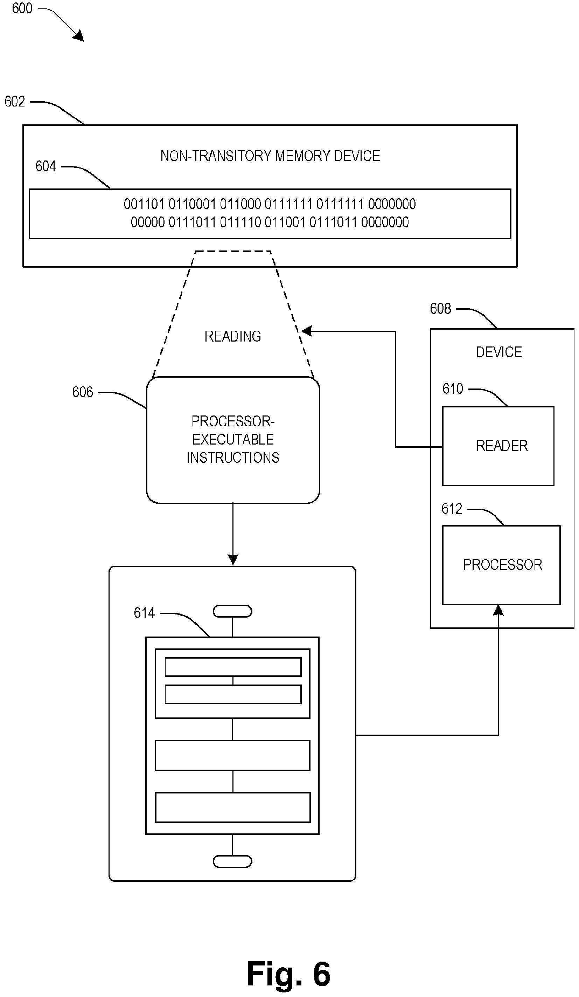

Fig. 6 illustrates an exemplary embodiment 600 of a computer-readable medium 602, in accordance with some embodiments. One or more embodiments involve a computer-readable medium comprising processor-executable instructions configured to implement one or more of the techniques presented herein. The embodiment 600 comprises a non-transitory computer-readable medium 602 (e.g., a CD-R, DVD-R, flash drive, a platter of a hard disk drive, etc.), on which is encoded computer-readable data 604. This computer-readable data 604 in turn comprises a set of processor-executable computer instructions 606 that, when executed by a computing device 608 including a reader 610 for reading the processor-executable computer instructions 606 and a processor 612 for executing the processor-executable computer instructions 606, are configured to facilitate operations according to one or more of the principles set forth herein. In some embodiments, the processor-executable computer instructions 606, when executed, are configured to facilitate performance of a method 614, such as at least some of the aforementioned method(s). In some embodiments, the processor-executable computer instructions 606, when executed, are configured to facilitate implementation of a system, such as at least some of the aforementioned system(s). Many such computer-readable media may be devised by those of ordinary skill in the art that are configured to operate in accordance with the techniques presented herein.

Configuring the battery clusters 102 to account for the propagation delay of the serial communication topology obviates the need for additional hardware and programming complexity of a parallel communication system without exceeding latency requirements. This approach reduces hardware cost, device footprint, and programming cost.

According to some embodiments, a method comprises connecting a first cluster controller of a first battery cluster to a serial communication bus, connecting a second cluster controller of a second battery cluster to the serial communication bus, sending synchronization data to the first cluster controller and the second cluster controller over the serial communication bus, controlling a first bridge of the first battery cluster to connect a first battery terminal of the first battery cluster to an output terminal based on the synchronization data and a first rank assigned to the first battery cluster to generate a first component of a waveform, and controlling a second bridge of the second cluster to connect a second battery terminal of the second battery cluster to the output terminal based on the synchronization data and a second rank assigned to the second battery cluster to generate a second component of the waveform.

According to some embodiments, sending the synchronization data comprises determining a propagation delay associated with the serial communication bus, assigning a first delay component to the first cluster controller based on the propagation delay, and assigning a second delay component to the second cluster controller based on the propagation delay, controlling the first bridge comprises sending a first bridge state command to the first cluster controller over the serial communication bus based on the first rank, and delaying execution of the first bridge state command based on the first delay component, and controlling the second bridge comprises sending a second bridge state command to the second cluster controller over the serial communication bus based on the second rank, and delaying execution of the second bridge state command based on the second delay component.

According to some embodiments, connecting the first cluster controller and the second cluster controller to the serial communication bus comprises connecting the first cluster controller and the second cluster controller to the serial communication bus using a serial transceiver, and determining the propagation delay associated with the serial communication bus comprises determining the propagation delay based on a delay associated with the serial transceiver.

According to some embodiments, delaying execution of the first bridge state command based on the first delay component comprises configuring a programmable delay counter in the first cluster controller with the first delay component, generating a bridge configuration signal responsive to the first bridge state command, delaying the bridge configuration signal in the programmable delay counter to generate a delayed bridge configuration signal, and controlling a bridge driver associated with the first bridge based on the delayed bridge configuration signal.

According to some embodiments, assigning the first delay component to the first cluster controller comprises assigning the first delay component to the first cluster controller based on the propagation delay and a position of the first cluster controller in the serial communication bus, and assigning the second delay component to the second cluster controller comprises assigning the second delay component to the second cluster controller based on the propagation delay and a position of the second cluster controller on the serial communication bus.

According to some embodiments, connecting the first cluster controller and the second cluster controller to the serial communication bus comprises connecting the first cluster controller and the second cluster controller to the serial communication bus in a ring topology.

According to some embodiments, connecting the first cluster controller to the serial communication bus comprises automatically assigning an address to the first cluster controller according to a protocol of the serial communication bus.

According to some embodiments, a battery cluster controller comprises a serial interface configured to receive synchronization data over a serial communication bus, a modulation unit configured to generate a bridge configuration signal to control a bridge for selectively connecting a battery element to an output terminal to generate a first component of a waveform based on a rank assigned to the battery cluster controller, and a delay unit configured to delay the bridge configuration signal based on the synchronization data to generate a delayed bridge configuration signal, wherein the bridge is controlled based on the delayed bridge configuration signal.

According to some embodiments, the synchronization data comprises a component of a total propagation delay for the serial communication bus, and the component is associated with a position of the battery cluster controller on the serial communication bus.

According to some embodiments, the position comprises a ring position in the serial communication bus.

According to some embodiments, the delay unit comprises a programmable delay counter configured based on the component.

According to some embodiments, the serial interface is configured to receive an address automatically assigned to the battery cluster controller according to a protocol of the serial communication bus.

According to some embodiments, a system comprises an output terminal, a serial communication bus, a first battery cluster comprises a first battery element, a first bridge configured to selectively connect the first battery element to the output terminal based on a state of the first bridge, and a first cluster controller connected to first bridge and the serial communication bus, a second battery cluster comprises a second battery element, a second bridge configured to selectively connect the second battery element to the output terminal based on a state of the second bridge, and a second cluster controller connected to the second bridge and the serial communication bus, and a host processor configured to send synchronization data to the first cluster controller and the second cluster controller over the serial communication bus, wherein the first cluster controller is configured to control the first bridge to connect the first battery element to the output terminal based on the synchronization data and a first rank assigned to the first battery cluster to generate a first component of a waveform, and the second cluster controller is configured to control the second bridge to connect the second battery element to the output terminal based on the synchronization data and a second rank assigned to the second battery cluster to generate a second component of the waveform.

According to some embodiments, the host processor is configured to determine a propagation delay associated with the serial communication bus, generate a first delay component in the synchronization data for the first cluster controller based on the propagation delay, and generate a second delay component in the synchronization data for the second cluster controller based on the propagation delay, send a first bridge state command to the first cluster controller over the serial communication bus based on the first rank, and send a second bridge state command to the second cluster controller over the serial communication bus based on the second rank, the first cluster controller is configured to delay execution of the first bridge state command to configure the state of the first bridge based on the first delay component, and the second cluster controller is configured to delay execution of the second bridge state command to configure the state of the second bridge based on the second delay component.

According to some embodiments, the system comprises a serial transceiver connecting the host processor to the serial communication bus, wherein the host processor is configured to determine the propagation delay based on a delay associated with the serial transceiver.

According to some embodiments, the first cluster controller comprises a serial interface, and the host processor is configured to determine the propagation delay based on a delay associated with the serial interface.

According to some embodiments, the first cluster controller comprises a first programmable delay counter configured based on the first delay component to delay the first bridge state command, and the second cluster controller comprises a second programmable delay counter configured based on the second delay component to delay the second bridge state command.

According to some embodiments, the first delay component is based on the propagation delay and a position of the first cluster controller on the serial communication bus, and the second delay component is based on the propagation delay and a position of the second cluster controller on the serial communication bus.

According to some embodiments, the serial communication bus is configured in a ring topology.

According to some embodiments, the system comprises a serial transceiver connecting the host processor to the serial communication bus and configured to automatically assigning a first address to the first cluster controller and a second address to the second cluster controller.

Various operations of embodiments are provided herein. The order in which some or all of the operations are described should not be construed to imply that these operations are necessarily order dependent. Alternative ordering will be appreciated having the benefit of this description. Further, it will be understood that not all operations are necessarily present in each embodiment provided herein. Also, it will be understood that not all operations are necessary in some embodiments.

Any aspect or design described herein as an "example" and/or the like is not necessarily to be construed as advantageous over other aspects or designs. Rather, use of the word "example" is intended to present one possible aspect and/or implementation that may pertain to the techniques presented herein. Such examples are not necessary for such techniques or intended to be limiting. Various embodiments of such techniques may include such an example, alone or in combination with other features, and/or may vary and/or omit the illustrated example.

Although the subject matter has been described in language specific to structural features and/or methodological acts, it is to be understood that the subject matter of the appended claims is not necessarily limited to the specific features or acts described above. Rather, the specific features and acts described above are disclosed as example forms of implementing at least some of the claims.

As used in this application, "or" is intended to mean an inclusive "or" rather than an exclusive "or". In addition, "a" and "an" as used in this application and the appended claims are generally to be construed to mean "one or more" unless specified otherwise or clear from context to be directed to a singular form. Also, at least one of A and B and/or the like generally means A or B or both A and B. Furthermore, to the extent that "includes", "having", "has", "with", or variants thereof are used, such terms are intended to be inclusive in a manner similar to the term "comprising". Also, unless specified otherwise, "first," "second," or the like are not intended to imply a temporal aspect, a spatial aspect, an ordering, etc. Rather, such terms are merely used as identifiers, names, etc. for features, elements, items, etc. For example, a first element and a second element generally correspond to element A and element B or two different or two identical elements or the same element.

Also, although the disclosure has been shown and described with respect to one or more implementations, equivalent alterations and modifications will occur to others skilled in the art based upon a reading and understanding of this specification and the annexed drawings. The disclosure includes all such modifications and alterations and is limited only by the scope of the following claims. In particular regard to the various functions performed by the above described components (e.g., elements, resources, etc.), the terms used to describe such components are intended to correspond, unless otherwise indicated, to any component which performs the specified function of the described component (e.g., that is functionally equivalent), even though not structurally equivalent to the disclosed structure which performs the function in the herein illustrated example implementations of the disclosure. In addition, while a particular feature of the disclosure may have been disclosed with respect to only one of several implementations, such feature may be combined with one or more other features of the other implementations as may be desired and advantageous for any given or particular application. Furthermore, to the extent that the terms "includes", "having", "has", "with", or variants thereof are used in either the detailed description or the claims, such terms are intended to be inclusive in a manner similar to the term "comprising."

While the subject matter has been described with reference to illustrative embodiments, this description is not intended to be construed in a limiting sense. Various modifications and combinations of the illustrative embodiments, as well as other embodiments of the present disclosure, will be apparent to persons skilled in the art upon reference to the description. It is therefore intended that the appended claims encompass any such modifications or embodiments.

**Claims**

1. A method, comprising:

   connecting a first cluster controller of a first battery cluster to a serial communication bus;
   connecting a second cluster controller of a second battery cluster to the serial communication bus;
   sending synchronization data to the first cluster controller and the second cluster controller over the serial communication bus;
   controlling a first bridge of the first battery cluster to connect a first battery terminal of the first battery cluster to an output terminal based on the synchronization data and a first rank assigned to the first battery cluster to generate a first component of a waveform; and
   controlling a second bridge of the second cluster to connect a second battery terminal of the second battery cluster to the output terminal based on the synchronization data and a second rank assigned to the second battery cluster to generate a second component of the waveform.

2. The method of claim 1, wherein:

   sending the synchronization data comprises:

   determining a propagation delay associated with the serial communication bus;
   assigning a first delay component to the first cluster controller based on the propagation delay; and
   assigning a second delay component to the second cluster controller based on the propagation delay;

   controlling the first bridge comprises:

   sending a first bridge state command to the first cluster controller over the serial communication bus based on the first rank; and
   delaying execution of the first bridge state command based on the first delay component; and

   controlling the second bridge comprises:

   sending a second bridge state command to the second cluster controller over the serial communication bus based on the second rank; and
   delaying execution of the second bridge state command based on the second delay component.

3. The method of claim 2, wherein:

   connecting the first cluster controller and the second cluster controller to the serial communication bus comprises:
   connecting the first cluster controller and the second cluster controller to the serial communication bus using a serial transceiver; and
   determining the propagation delay associated with the serial communication bus comprises determining the propagation delay based on a delay associated with the serial transceiver.

4. The method of claim 2, wherein delaying execution of the first bridge state command based on the first delay component comprises:

   configuring a programmable delay counter in the first cluster controller with the first delay component;
   generating a bridge configuration signal responsive to the first bridge state command;
   delaying the bridge configuration signal in the programmable delay counter to generate a delayed bridge configuration signal; and
   controlling a bridge driver associated with the first bridge based on the delayed bridge configuration signal.

5. The method of claim 2, wherein:

   assigning the first delay component to the first cluster controller comprises assigning the first delay component to the first cluster controller based on the propagation delay and a position of the first cluster controller in the serial communication bus; and
   assigning the second delay component to the second cluster controller comprises assigning the second delay component to the second cluster controller based on the propagation delay and a position of the second cluster controller on the serial communication bus.

6. The method of any one of claims 1 - 5, wherein connecting the first cluster controller and the second cluster controller to the serial communication bus comprises:
   connecting the first cluster controller and the second cluster controller to the serial communication bus in a ring topology.

7. The method of any one of claims 1 - 6, wherein connecting the first cluster controller to the serial communication bus comprises:
   automatically assigning an address to the first cluster controller according to a protocol of the serial communication bus.

8. A system, comprising:

an output terminal;
a serial communication bus;
a first battery cluster comprising:

a first battery element;
a first bridge configured to selectively connect the first battery element to the output terminal based on a state of the first bridge; and
a first cluster controller connected to first bridge and the serial communication bus;

a second battery cluster comprising:

a second battery element;
a second bridge configured to selectively connect the second battery element to the output terminal based on a state of the second bridge; and
a second cluster controller connected to the second bridge and the serial communication bus; and

a host processor configured to send synchronization data to the first cluster controller and the second cluster controller over the serial communication bus, wherein:

the first cluster controller is configured to control the first bridge to connect the first battery element to the output terminal based on the synchronization data and a first rank assigned to the first battery cluster to generate a first component of a waveform; and
the second cluster controller is configured to control the second bridge to connect the second battery element to the output terminal based on the synchronization data and a second rank assigned to the second battery cluster to generate a second component of the waveform.

9. The system of claim 8, wherein:

the host processor is configured to:

determine a propagation delay associated with the serial communication bus;
generate a first delay component in the synchronization data for the first cluster controller based on the propagation delay; and
generate a second delay component in the synchronization data for the second cluster controller based on the propagation delay;
send a first bridge state command to the first cluster controller over the serial communication bus based on the first rank; and
send a second bridge state command to the second cluster controller over the serial communication bus based on the second rank;

the first cluster controller is configured to delay execution of the first bridge state command to configure the state of the first bridge based on the first delay component; and
the second cluster controller is configured to delay execution of the second bridge state command to configure the state of the second bridge based on the second delay component.

10. The system of claim 9, comprising:
a serial transceiver connecting the host processor to the serial communication bus, wherein:
the host processor is configured to determine the propagation delay based on a delay associated with the serial transceiver.

11. The system of claim 10, wherein:

the first cluster controller comprises a serial interface; and
the host processor is configured to determine the propagation delay based on a delay associated with the serial interface.

12. The system of any one of claims 9 - 11, wherein:

the first cluster controller comprises a first programmable delay counter configured based on the first delay component to delay the first bridge state command; and

the second cluster controller comprises a second programmable delay counter configured based on the second delay component to delay the second bridge state command.

13. The system of any one of claims 9 - 12, wherein:

the first delay component is based on the propagation delay and a position of the first cluster controller on the serial communication bus; and

the second delay component is based on the propagation delay and a position of the second cluster controller on the serial communication bus.

14. The system of any one of claims 8 - 13, wherein:
the serial communication bus is configured in a ring topology.

15. The system of any one of claims 8 - 14, comprising:
a serial transceiver connecting the host processor to the serial communication bus and configured to automatically assigning a first address to the first cluster controller and a second address to the second cluster controller.

**Fig. 1**

**Fig. 2**

108B

116

**Cluster Controller N**

PHY — Serial Interface — Trigger — Trigger MUX — Trigger — PWM1 — 306 — Delay Counter = 0*Delay/(N+2) — 310 — ARM1 — H-Bridge Driver — 122

PWM2 — Delay Counter = 0*Delay/(N+2) — ARM2

300    302    304    308    312

116

**Cluster Controller 2 - N-1**

TRG

| | | | | |
|---|---|---|---|---|
| ARM1 | 1 | 0 | 0 | 0 | 1 |
| ARM2 | 0 | 0 | 1 | 0 | 0 |

+VE | 0V | -VE | 0V | +VE

116

**Cluster Controller 1**

PHY — Serial Interface — Trigger — Trigger MUX — Trigger — PWM1 — 306 — Delay Counter = (N-1)*Delay/(N+2) — 310 — ARM1 — H-Bridge Driver — 122

PWM2 — Delay Counter = (N-1)*Delay/(N+2) — ARM2

300    302    304    308    312

**Fig. 3**

14

Fig. 4

500

CONNECT FIRST CLUSTER CONTROLLER OF FIRST BATTERY CLUSTER TO SERIAL COMMUNICATION BUS ⎯ 502

CONNECT SECOND CLUSTER CONTROLLER OF SECOND BATTERY CLUSTER TO SERIAL COMMUNICATION BUS ⎯ 504

SEND SYNCHRONIZATION DATA TO FIRST CLUSTER CONTROLLER AND SECOND CLUSTER CONTROLLER OVER SERIAL COMMUNICATION BUS ⎯ 506

CONTROL FIRST BRIDGE OF FIRST CLUSTER TO CONNECT FIRST BATTERY TERMINAL OF FIRST BATTERY CLUSTER TO OUTPUT TERMINAL BASED ON SYNCHRONIZATION DATA AND FIRST RANK ASSIGNED TO FIRST BATTERY CLUSTER TO GENERATE FIRST COMPONENT OF WAVEFORM ⎯ 508

CONTROL SECOND BRIDGE OF SECOND CLUSTER TO CONNECT SECOND BATTERY TERMINAL OF SECOND BATTERY CLUSTER TO OUTPUT TERMINAL BASED ON SYNCHRONIZATION DATA AND SECOND RANK ASSIGNED TO SECOND BATTERY CLUSTER TO GENERATE SECOND COMPONENT OF WAVEFORM ⎯ 510

# Fig. 5

600

602

NON-TRANSITORY MEMORY DEVICE

604

001101 0110001 011000 0111111 0111111 0000000
00000 0111011 011110 011001 0111011 0000000

READING

606

PROCESSOR-
EXECUTABLE
INSTRUCTIONS

608

DEVICE

610

READER

612

PROCESSOR

614

**Fig. 6**

Europäisches
Patentamt

European
Patent Office

Office européen
des brevets

# EUROPEAN SEARCH REPORT

**Application Number**

EP 24 19 7485

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2018/145150 A1 (RELECTRIFY PTY LTD [AU]) 16 August 2018 (2018-08-16) | 1,8 | INV. H02J7/00 |
| Y | * figures 1-3, 6, 8, 12-17 * <br> * page 12, line 15 - page 15, line 20 * <br> * page 12, line 15 - page 17, line 20 * <br> * page 14, line 5 - page 15, line 20 * <br> * page 17, line 21 - page 23, line 2 * <br> * page 17, line 21 - page 27, line 20 * <br> * page 31, line 19 - page 35, line 8 * <br> ----- | 2-7,9-15 | H02M7/483 |
| Y | US 2021/075227 A1 (CHANG WEI-HSU [TW]) 11 March 2021 (2021-03-11) <br> * figures 2, 3 * <br> * paragraph [0042] - paragraph [0043] * <br> * paragraph [0042] - paragraph [0050] * <br> ----- | 2-7,9-15 | |
| A | WO 2021/094011 A1 (SEM AB [SE]) 20 May 2021 (2021-05-20) <br> * abstract * <br> * the whole document * <br> ----- | 1,8 | |
| A | WO 2022/094925 A1 (TEXAS INSTRUMENTS INC [US]; TEXAS INSTRUMENTS JAPAN LTD [JP]) 12 May 2022 (2022-05-12) <br> * abstract * <br> * the whole document * <br> ----- | 3,10,11 | **TECHNICAL FIELDS SEARCHED (IPC)** <br> H02J <br> H02M |

The present search report has been drawn up for all claims

| Place of search | Date of completion of the search | Examiner |
|---|---|---|
| Munich | 3 December 2024 | Oiring, Vinicius |

EPO FORM 1503 03.82 (P04C01)

## ANNEX TO THE EUROPEAN SEARCH REPORT
## ON EUROPEAN PATENT APPLICATION NO.

EP 24 19 7485

This annex lists the patent family members relating to the patent documents cited in the above-mentioned European search report.
The members are as contained in the European Patent Office EDP file on
The European Patent Office is in no way liable for these particulars which are merely given for the purpose of information.

03-12-2024

| Patent document cited in search report | | Publication date | Patent family member(s) | | Publication date |
|---|---|---|---|---|---|
| WO 2018145150 | A1 | 16-08-2018 | AU | 2018218181 A1 | 19-09-2019 |
| | | | CN | 110521078 A | 29-11-2019 |
| | | | EP | 3580828 A1 | 18-12-2019 |
| | | | JP | 6989620 B2 | 05-01-2022 |
| | | | JP | 2020507303 A | 05-03-2020 |
| | | | KR | 20190116329 A | 14-10-2019 |
| | | | US | 2019363311 A1 | 28-11-2019 |
| | | | WO | 2018145150 A1 | 16-08-2018 |
| | | | ZA | 201905936 B | 27-01-2021 |
| US 2021075227 | A1 | 11-03-2021 | TW | 202112028 A | 16-03-2021 |
| | | | US | 2021075227 A1 | 11-03-2021 |
| WO 2021094011 | A1 | 20-05-2021 | CN | 114946096 A | 26-08-2022 |
| | | | EP | 4059107 A1 | 21-09-2022 |
| | | | SE | 1951301 A1 | 12-05-2021 |
| | | | WO | 2021094011 A1 | 20-05-2021 |
| WO 2022094925 | A1 | 12-05-2022 | CN | 116529617 A | 01-08-2023 |
| | | | US | 2022146581 A1 | 12-05-2022 |
| | | | WO | 2022094925 A1 | 12-05-2022 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63536326 B